Europäisches Patentamt

European Patent Office

Office européen des brevets

(19)

(11) Publication number:
0 373 637
A2

## (12) EUROPEAN PATENT APPLICATION

(21) Application number: 89123072.4

(22) Date of filing: 13.12.89

(51) Int. Cl.5: H01S 3/19, H01L 33/00

(30) Priority: 15.12.88 HU 643288

(43) Date of publication of application:
20.06.90 Bulletin 90/25

(84) Designated Contracting States:
AT BE CH DE ES FR GB GR IT LI LU NL SE

(71) Applicant: MAGYAR TUDOMANYOS
AKADEMIA MÜSZAKI FIZIKAI KUTATO
INTEZETE
Foti ut 56
Budapest IV. Ujpest(HU)

(72) Inventor: Rakovics, Vilmos,
Mártirok utja 11,
1024 Budapest(HU)
Inventor: Lendvay, Ödön Dr.,
Gellérthegy u. 5,
1016 Budapest(HU)
Inventor: Lábadi, Zoltán,
Harcsa u. 2,
1023 Budapest(HU)
Inventor: Habermayer, István Dr.,
Várfok u. 2/b,
1026 Budapest(HU)

(74) Representative: Patentanwälte Viering &
Jentschura
Steinsdorfstrasse 6
D-8000 München 22(DE)

(54) InP/GaInAsP double heterostructure laser diode with buried active layer, and method for its production.

(57) InP/GaInAsP double heterostructure laser diode with buried active layer, and method for its production. The InP/GaInAsP laser diode containing a built-in isolating p-n junction with a double channeled double heterostructure carrier, and a buried active layer built up on an InP substrate, is prepared by using the method of one-step liquid phase epitaxy, wherein on the orientated substrate (1) there are formed two parallel channels (9), between which channels (9) a buried GaInAsP active layer (3a) is arranged, which is confined on all sides by n and p type InP layers with a wide inhibiting zone and a low refractive index. On the substrate (1) there is a n-type InP buffer layer (2) and thereon a further GaInAsP layer (3) with narrow gap and lying at the bottom of the channels (9) and on the planar parts, whereon a further n-type layer (4) is arranged carrying a further n-type current-limiting layer (5), whereon an InP embedding layer (6) is provided on which a GaInAsP contact layer (7) of the p-type is arranged, while this one is covered with a multilayer p-side contact-metal layer (8a), advantageously of Au/Au-Zn, while on the other side of the carrier a n-side contact-metal layer (8b) is directly arranged, preferably consisting of AuGe/Ni/Au.

Fig.1

## InP/GaInAsP double heterostructure laser diode with buried active layer, and method for its production

The invention relates to an InP/GaInAsP double heterostructure laser diode with a buried active layer and builtin isolating p-n junctions on a double channeled substrate, and to a method for its production by means of the one-step liquid phase epitaxy.

The radiation range of the InP/GaInAsP lasers corresponds to the attenuation minimum of optical fibres used in phototelecommunication; accordingly, worldwide research activity has been directed to the improvement of said lasers. Lasers used in optical-telecommunication have to meet the following main requirements: low threshold current, high efficiency, function within a wide range of temperature, stable distribution of radiation.

Only lasers with a narrow buried active layer can meet said requirements. In technical literature several laser types have been described, which are able to meet said requirements, however their realization is very complicated and expensive, as a multi-step lithographic process or multi-stage crystal growth technology (molecular beam epitaxy metal organic chemical vapour deposition, liquid phase epitaxy) are to be applied, in addition oxide growing and diffusion steps are also contained.

Parameters of the lasers developed in accordance with the inventionn correspond to the parameters of the lasers produced by more complicated processes. At the same time their production do not require but one stage of lithography and one stage of liquid phase epitaxial technology.

This aim is reached according to the invention by the measures stated in the claims.

The invention will be described in detail with reference to the figures enclosed, wherein

figure 1 shows the structural layout of the laser diode according to the invention, and

figure 2 shows the scheme of production of the laser diode according to the invention.

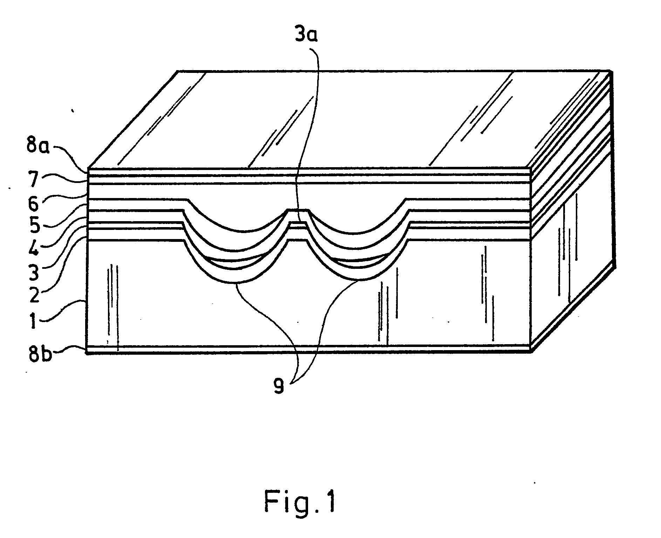

As it becomes obvious from figure 1, the laser diode is grown on a double channeled substrate. The narrow buried active GaInAsP layer between the channels is confined by InP layers of the type n- and -p with a wider inhibiting zone and a lower refractive index. The optical cavity is completed by the cleaved frontal surfaces. Recombination of charge carriers and stimulated emission can be established in a very small volume, because the dimensions of the active range of the laser are, as follows: length 200-500 $\mu$m, width: 1-3$\mu$m, height: 0,1-0,2 $\mu$m. Outside the active layer a thyristor-like p-n-p GaInAsP-n structure limits the current. The low resistance current input will be achieved with alloyed metal contacts with large surfaces which enable simultaneously favourable heat conductivity. Both sides of the laser chip are completely planar, accordingly, it can be easily assembled onto the cooling block.

The construction as detailed above enables the operation with 50 % efficiency. In continuous mode of operation the threshold current of lasers amounts to 20-50 mA, while the maximal output power reaches 10 mW in some cases. The half-width or the far-field radiation distribution anmounts to 30-45 as parallel with junction as perpendicularly thereto. The laser developed according to the invention is similar to the "double channel planar buried heterostructure laser" prepared by the two-step epitaxy, well known from technical literature. In addition to facilitated production the laser developed according to the invention has a much better current-confining structure, as a narrow GaInAsP inhibiting zone is present not only outside the channels but even in the channels themselves, preventing breakdown of the layers. In such a manner the thickness of the active range can better be controlled, because the active layer will grow more slowly, due to the quicker growth in the channels, however in a better controlled way.

In contrast to the buried double heterostructure lasers having been prepared by one-step epitaxy, on a mesa-stripe the advantage of the double channeled laser is, that it contains a builtin p-n junction. Accordingly, it becomes superfluous to solve current confinement by means of oxide stripe insulation. A further disadvantage of the laser formed on the mesa-stripe -as described earlier - lies in that their surface is not completely planar. As a consequence, they can be mounted onto the cooling block with difficulties only. With the method according to the invention, however, this problem does not arise, due to the completely planar surfaces obtained by the technology.

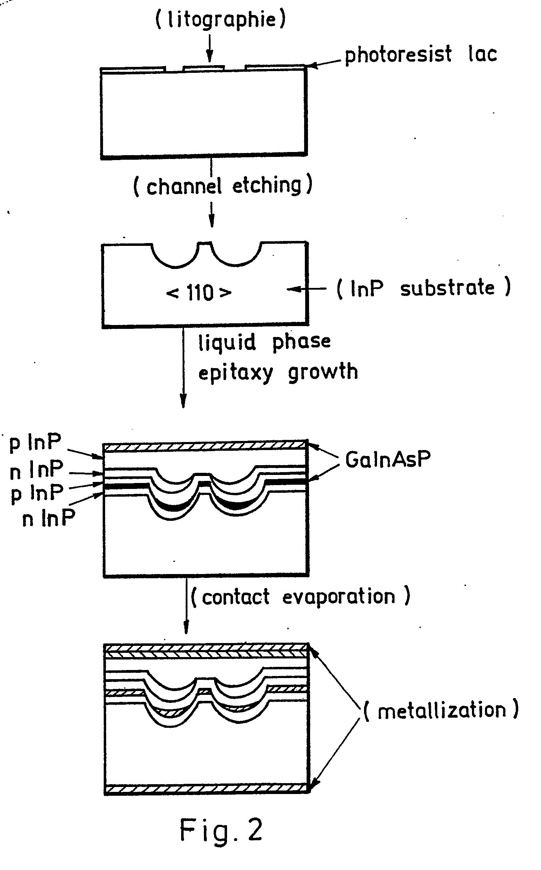

Figure 2 illustrates the scheme of production of the InP/GaInAsP laser with the double channel substrate.

Windows consisting of stripe-pairs are opened by etching in parallel with the <110> cristallographical direction by means of positive photoresistent masks. The distance between the 4 $\mu$m wide windows amounts to 6 $\mu$m, while the distance between the pairs of stripes equals to 400 $\mu$m. By using the mixture of acidic acid, hydrogen bromide and 0,1 N KMnO$_4$ solution in the proportion of 5:1:1 we are etching 3-5 $\mu$m deep channels. As a consequence of under-etching the width of the channels will equal to 7-9 $\mu$m, while the mesa-stripe is 1-3 $\mu$m wide. After having removed photoresistent masks the InP substrate is cleaned with sulphuric acid-peroxide and is placed into the epitaxial reactor.

In course of the epitaxial growth, the following layers are formed on the substrate, in the temperature range of 600-650 C°, by using the liquid phase epitaxial method:
- n-InP buffer layer, thickness: 0,5-1 $\mu$m, Sn: $\approx 10^{18}$
- active GaInAsP layer undoped, thickness: 0,1-0,2 $\mu$m, Eg:1,3 $\mu$m
- p-InP cladding layer thickness: 0,5-1 $\mu$m, Zn: 3-7 x $10^{17}$
- n-InP current confining layer 0,5-1,5 $\mu$m thick, Te:2-3x $10^{18}$
- p-InP second embedding layer, 2-4 $\mu$m thick, Zn: 5-8 x $10^{17}$
- p+-GaInAsP contact layer, thickness: 0,5 $\mu$m, Eg: 1,03 $\mu$m

The wafer containing the laser structure is thinned to 100-200 $\mu$m on the backside, thereafter onto the p-side a contact layer Au/Au/Zn (200/1400 Å), onto the n-side AuGe/Ni/Au (3000/700/1000 Å) is allowed to evaporate, while the contacts are subjected to heat treatment at 420° C, for 10 seconds in a forming gas.

Laser chips are formed by cleaving and, after having performed selection, are mounted onto the cooling block and are provided with wiring in the terminal areas.

For the sake of better understanding, we describe the mode of realization of producing a laser diode:
- The substrate applied : 20 x 10 x 0,4 mm, polished InP wafer
- orientation : <100> , lateral edge 10 mm runs parallel with direction <110>,
- Charge-carrier concentration: n: 1.8 x $10^{18}$/cm$^3$
- Dislocation density: (EDP) 3 x 104/cm$^2$.

The substrate is etched in a 1% Br-methanol solution for 2 minutes, thereafter it is flushed with methanol. The pattern needed for forming the pair of channels will be formed by means of photolithography, by using positive laquer. The windows formed in the laquer are <110> oriented and 6 $\mu$m wide and they are arranged by pairs in a mutual distance of 6,5 $\mu$m. The distance between the single band pairs amounts to 400 $\mu$m. The channels are formed by help of the windows formed in the laquer by chemical etching. Etching is performed in the etching mixture 1 HBr : 1ccK$_2$Cr$_2$O$_7$ : 5 CH$_3$COOH, duration of etching: 30 seconds. Due to under-etching, the width of the channels equals to 10 $\mu$m, the depth to 3,5 $\mu$m. The width of the mesa-band between the channels equals to 2 $\mu$m. After having removed the mask, the substrate surface is cleaned in a mixture of 5 H$_2$SO$_4$ : 1 H$_2$O and is flushed with distilled water and 5% HCl. The substrate is dried in N$_2$ and placed into the epitaxial reactor, where it is stored up to the beginning of the growing process.

- One-step liquid phase epitaxial growing of the laser structure is performed in a semipermeable gold shielded reactor with low heat inertness by allowing Hz to flow through the reactor. Epitaxial layers are grown from the melts arranged in the graphite boat. For preparing melts we use In, InP, GaAs and InAs of 6N purity, as well as Sn, Te and Zn as doping materials. For preparing the single melts,the following materials are weighed in:

1. 4,81282 g In; 40,47 mg InP; 120mg Sn
2. 4,6941 g In; 10,99 mg InP; 54,54 mg GaAs; 289,81 mg InAs
3. 5,3843 g In; 45,23 mg InP; 43,07 mg Zn-In alloy (0,5% Zn)
4. 5,1467 g In; 38,60 mg InP; 2,06 mg Te
5. 5,4411 g In; 39,17 mg InP; 43,53 mg Zn-In alloy (0,5% Zn.)
6. 5,2972 g In; 20,86 mg InP; 21,96 mg GaAs, 201,82 g InAs; 4,23 mg In

Materials and the substrate are placed into the graphite casettes the substrate being protected by means of an InP covering wafer against thermic decomposition. The reactor is flushed with a hydrogen, thereafter the reactor is heated to 670 °C and held at said temperature for half an hour; meanwhile materials having been weighed in are dissolved in In. After a holding time of 30 minutes the system is cooled to 635 °C with a cooling speed of 5 °C/minute, then from 635 °C to 610 °C with a cooling speed of 0,5 °C/minute. Layer growth begins at 627 °C and in such a manner that the first melt is pushed onto the InP-carrier.

Layers are grown with linear cooling speed for the following durations:

| | |
|---|---|
| 1. layer at 627 °C | 20 seconds |
| 2. layer at 627 °C | 5 seconds |
| 3. layer at 627 °C | 30 seconds |
| 4. layer at 626-625 °C | 2 minutes |
| 5. layer at 625-618 °C | 14 minutes |
| 6. layer at 618 °C | 1 minute |

After having finished growing the last melt is pushed down from the carrier and the equipment is cooled (e.g. by disconnecting heating). The surface of the grown structure is cleaned from the drops adhering thereon with a hydrochloric acid - peroxide solution.

Perpendicularly to the channels a part is cleaved from the segment which is etched for 10 seconds with alkaline $K_3[Fe(CN)_6]$ solution, measured electromicroscopally to obtain thickness and width of the active layer. The backside of the substrate is thinned to 180 $\mu$m by using abrasive powder SiC with a grainsize of 7 $\mu$m and $Al_2O_3$ of a grainsize of 3-4 $\mu$m, thereafter polishing is performed by using chemical-mechanical methods; as polishing means we use 20% ethylene glycol, 77% methanol, 3% $Br_2$. After having finished the process, the final thickness of the wafer amounts to 120 $\mu$m.

The segment is provided with contacts by vacuum evaporation. The metals are evaporated in $10^{-3}$-$10^{-4}$ Pa vacuum. The sample is arranged at a distance of O,8 cm from the source. For preparing contact for the p-side 10 mg Au and 60 mg Au-Zn (10%) alloy are measured into the evaporating boat W. First gold, thereafter Au-Zn are allowed to evaporate. The segment is turned and the surface of the substrate is metallized with Au-Ge-Ni. As a source 150 mg eutecticum and 15 mg Ni are used.

After having finished evaporation the metallization is treated in a forming gas containing 20% $H_2$ at 420 $^\circ$C for 10 seconds.

Following heat treatment a fresh Au-layer is applied onto the n-side of the wafer. The sample is heated to 150 $^\circ$C while being allowed to evaporate to promote adhesion of Au. The metallized wafer is cleaved into laser diode chips of the size 200 x 400 $\mu$m, the chips thus obtained are soldered in a face-down arrangement onto the cooling block or a proper frame. Upper leading is realized in the usual way by thermocompression or ultrasonic bond.

**Claims**

1. InP/GaInAsP laser diode containing a built-in isolating p-n junction with a double channeled double heterostructure carrier, comprising a buried active layer built up on an InP substrate, characterized in that on the orientated substrate (1) there are two parallel channels (9), between which channels (9) a buried GaInAsP active layer (3a) is arranged, which is confined on all sides by n and p type InP layers with a wide inhibiting zone and a low refractive index, that on the substrate (1) there is formed a n-type InP buffer layer (2) and thereon a further GaInAsP layer (3) with narrow gap and lying at the bottom of the channels (9) and on the planar parts, that thereon a further n-type layer (4) is arranged carrying a further n-type current-limiting layer (5), whereon an InP embedding layer (6) is provided on which a GaInAsP contact layer (7) of the p-type is arranged, while this one is covered with a multilayer p-side contact-metal layer (8a), advantageously of Au/AuZn, while on the other side of the carrier a n-side contact-metal layer (8b) is directly arranged, preferably consisting of AuGe/Ni/Au.

2. Method for producing a laser diode as claimed in claim 1 by using the method of liquid phase epitaxy, in the course of which orientation, photolithography, etching, liquid-epitaxial enhancement, metallization and cleaving are used, characterized in that in the course of producing the laser structure, first of all the carrier is prepared in the following way:
- an InP substrate is orientated by cleaving in the <110> crystallographic direction and by etching, then
- an etching window parallel with the <110> crystallographical direction is opened by using photolithography, windows of the width of 4 $\mu$m are arranged in a distance of 6 $\mu$m, while the distance between the stripe-pairs amounts preferably to 400 $\mu$m, followed by
- forming channels, expediently with a depth of 3-5 $\mu$m, by etching, using acidic acid, hydrogen bromide and O,1 N $KMO_4$ solution mixed in a proportion of 5:1:1, and
- removing the photo-resistent laquers and cleaning the segment;
that the pretreated InP substrate is put into the epitaxial reactor and the laser structure is prepared by using the one-step epitaxy so that the following layers are grown onto the InP carrier in the following order of sequence:
- n-InP buffer layer (2), preferably 0,5-1 $\mu$m thick, with Sn $10^{18}/cm^3$ dopant,
- GaInAsP active layer (3a) undoped, preferably in a thickness of O,1-O,2 $\mu$m and Eg = 1,3 $\mu$m,
- p-InP confining layer (4), preferably O,5-1 $\mu$m thick, Zn: 3-7 x $10^{17}/cm^3$ as dopant,
- n-InP current limiting layer (5), preferably in a thickness of O,5-1,5 $\mu$m, Te: 2-3 x $10^{18}/cm^3$ as dopant
- p-InP as embedding layer (6), preferably 2-4 $\mu$m thick, Zn: 5-8 x $10^{18}/cm^3$ as dopant,
- $p^+$ Ga InAsP contact layer, thickness: preferably O,5$\mu$m, Eg = 1,03 $\mu$m;

and that the wafer containing the laser structure grown in the described way, is thinned on the backside (17) preferably to 100-200 $\mu$m, and then, onto the p-side (16), a contact metal layer (8a), preferably of Au/AuZn is applied in a thickness of 200-1400 Å, while onto the n-side (17) a contact metal layer (8b) is applied, preferably AuGe/Ni/Au in a thickness of 3000/700/1000 Å by means of vaporization, whereafter the contact layers (8a,8b) are subjected to a heat treatment at 420 °C in a $H_2$ gas space, preferably for 10 seconds.

Fig.1

( litographie )

photoresist lac

( channel etching )

< 110 >    ( InP substrate )

liquid phase
epitaxy growth

p InP
n InP
p InP
n InP

GaInAsP

( contact evaporation )

( metallization )

Fig. 2